# EUROPÄISCHE PATENTANMELDUNG

(11) **EP 2 666 883 A1**
(43) Veröffentlichungstag der Anmeldung: **27.11.2013**
(21) Anmeldenummer: 13166496.3
(22) Anmeldetag: 03.05.2013
(51) Int. Cl.: C23C 4/12, C23C 16/513

(54) **Verfahren zur Modifkation eines Grenzbereichs eines Substrats**

(30) Priorität: 24.05.2012 EP 12169320
(71) Anmelder: Sulzer Metco AG, 5610 Wohlen (CH)
(72) Erfinder: Gindrat, Malko Dr., 5610 Wohlen (CH); Guittienne, Philippe Dr., 1092 Belmont-sur-Lausanne (CH); Hollenstein, Christoph Dr., 1095 Lutry (CH)
(74) Vertreter: Sulzer Management AG

(57) **Zusammenfassung**

Verfahren zur Modifikation eines durch eine Oberfläche (10) begrenzten Grenzbereichs (9) eines Substrats (3), wobei eine evakuierte Prozesskammer (2) mit einer Plasmaquelle (4) zur Erzeugung eines gerichteten Plasmastrahls (5) zur Verfügung gestellt wird, und ferner eine reaktive Komponente in die Prozesskammer (2) mit einem Fluss vorgegebener Grösse zugeführt wird und wobei das Substrat (3) auf eine vorgegebene Reaktionstemperatur erhitzt wird, dadurch gekennzeichnet, dass die reaktive Komponente durch den gerichteten Plasmastrahl (5) derart diffusionsaktiviert wird, sodass die reaktive Komponente mit einer vorgebbaren Diffusionsrate in den Grenzbereich (11) des Substrats (3) diffundiert.

## Beschreibung

Die Erfindung betrifft ein Verfahren zur Modifikation eines durch eine Oberfläche begrenzten Grenzbereichs eines Substrats gemäss dem Oberbegriff des unabhängigen Anspruchs 1.

Unter Oberflächenveredelung versteht man die verschiedensten technischen Methoden, um die Oberflächeneigenschaften von Substraten zu verbessern bzw. zu verändern. Im Wesentlichen werden dabei die funktionalen und dekorativen Eigenschaften der Oberfläche eines Substrates verändert, wobei mit funktionalen Eigenschaften die Verbesserung von Oberflächen, beispielsweise bzgl. Korrosionsschutz oder Verschleißschutz, oder dekorative Eigenschaften, beispielsweise der Glanzgrad oder die Farbe, gemeint sind. Bekannte Beispiele für oberflächenveredelte Produkte sind Kunststoff- oder Metallteile, beispielsweise DVDs oder Werkzeuge deren Kratzfestigkeit verbessert wird, oder die Herstellung von schmutzabweisenden Oberflächen auf Glas und Keramik (Lotuseffekt).

Zwei zur Oberflächenveredelung eingesetzte methodische Klassen sind Beschichtungsverfahren sowie die Modifikation eines Schichtbereiches im Substrat. Die wesentlichen Methoden der ersten Klasse, also die Beschichtungsverfahren, sind z.B. die physikalische Gasphasenabscheidung, die chemische Gasphasenabscheidung und das thermische Spritzen, insbesondere das Plasmaspritzen, aber auch klassische Methoden, wie z.B. Lackieren. Der Begriff physikalische Gasphasenabscheidung (englisch physical vapour deposition, kurz PVD), bezeichnet dabei eine Gruppe von vakuumbasierten Beschichtungsverfahren bzw. Dünnschichttechnologien. Dabei wird mithilfe physikalischer Verfahren das Beschichtungsmaterial in die Gasphase überführt und das gasförmige Material kondensiert auf dem Substrat, wobei die Zielschicht gebildet wird.

Bei der chemischen Gasphasenabscheidung (englisch chemical vapour deposition, kurz CVD) wird hingegen die Gasphase einer Feststoffkomponente oft an der erhitzten Oberfläche eines Substrates aufgrund einer chemischen Reaktion abgeschieden. Das Verfahren zeichnet sich dabei meist durch eine chemische Reaktion in der Prozesskammer oder an der Oberfläche des zu beschichtenden Werkstücks aus. Eine wesentliche Einschränkung des Verfahrens stellt die oft hohe Temperaturbelastung des Substrates dar. Die Wärmebelastung kann unter anderem Verzug an Werkstücken bedingen oder oberhalb der Erweichungstemperatur des zu beschichtenden Materials liegen, sodass das Verfahren nicht oder nur bedingt angewendet werden kann.

Bei einer weiteren Kategorie an Beschichtungsverfahren, das thermische Spritzen, werden Zusatzwerkstoffe, die so genannten Spritzzusätze, innerhalb oder außerhalb eines Spritzbrenners ab-, an- oder aufgeschmolzen, in einem Gasstrom in Form von Spritzpartikeln beschleunigt und auf die Oberfläche des zu beschichtenden Bauteils geschleudert. Eine Schichtbildung findet statt, da die Spritzpartikel beim Auftreffen auf die Bauteiloberfläche prozess- und materialabhängig mehr oder minder abflachen, vorrangig durch mechanische Verklammerung haften bleiben und so die Spritzschicht aufbauen.

Die für die verschiedenen Methoden verwendeten Geräte, beispielsweise Vakuumaufdampfanlagen, Sputteranlagen, Anlagen für CVD und thermische Spritzgeräte, zum Beispiel thermische Plasmaspritzgeräte, finden heute in vielen Bereichen der industriellen Fertigung Anwendung.

Typische Substrate umfassen zum Beispiel Werkstücke mit gekrümmten oder nicht gekrümmten Oberflächen, beispielsweise Werkzeuge oder Zylinderlaufflächen von Verbrennungsmotoren, eine Vielzahl von Bauteilen und Halbfabrikaten, auf denen mittels eines thermischen Spritzverfahrens zum Beispiel ein Korrosionsschutz aufgebracht wird, aber auch ebene Substrate wie Wafer und Folien, auf die eine Beschichtung aufgebracht wird, also unter anderem leitende oder isolierende Schichten für Halbleiter, wie Solarzellen. Die aufgebrachten Schichten können dazu verwendet werden, die Oberfläche widerstandsfähig gegen Hitze, mechanische, chemische, oder korrosive Einflüsse zu machen, die Reibung oder Haftung auf der Oberfläche zu verbessern, die Oberflache elektrisch und / oder thermisch isolierend oder fallweise leitend zu machen, die Oberfläche für Lebensmittel geeignet oder für Blut oder Gewebe verträglich zu machen, oder um Abdichtungen und Diffusionssperren zu bilden, um nur einige typische Anwendungen zu nennen.

Zur reaktiven Vorbehandlung der äusseren Oberfläche, also zum Beispiels zur Aktivierung der Oberfläche vor einem Beschichtungsvorgang, und zur Abscheidung dünner Schichten mittels eines Plasmas sind bereits verschiedenste Anlagen und Verfahren aus dem Stand der Technik bekannt. Ein thermisches Spritzverfahren mit Plasma ist in der EP 2 107 131 A1 beschrieben. Das dort beschriebene Verfahren behandelt ein Verfahren zum Beschichten und / oder zur Oberflächenbehandlung von Substraten durch einen Plasmastrahl, welcher in einer Prozesskammer mittels einer Plasmaquelle erzeugt wird. Dabei wird Plasmagas durch die Plasmaquelle geleitet, das Plasmagas mittels elektrischer Gasentladung und / oder elektromagnetischer Induktion und / oder Mikrowellen aufgeheizt und der Plasmastrahl auf ein in die Prozesskammer eingebrachtes Substrat gelenkt. Das Verfahren zeichnet sich dadurch aus, dass in den Plasmastrahl eine reaktive Komponente in flüssiger oder gasförmiger Form injiziert wird, um eine Oberfläche des Substrats zu beschichten bzw. um die äussere Oberfläche vor dem Beschichten vorzubehandeln, also zu aktivieren, um eine bessere Haftung der Beschichtung zu erreichen. Die reaktive Komponente wird der Plasmaquelle dabei in gasförmiger oder flüssiger Form zugeführt. Mögliche Aktivierungsvorgänge, um die Haftung der Beschichtung auf der Oberfläche des Substrats zu verbessern, umfassen beispielsweise das Aufheizen, Reinigen, Ätzen, Anoxidieren oder Annitrieren der äusseren Oberfläche, z.B. mittels eines Plasmastrahls.

Wesentliche Nachteile des in der in EP 2 107 131 A1 beschriebenen Verfahren sind, dass die Vorbehandlung, also die Aktivierung der Oberfläche, sowie das Beschichten der Oberfläche sehr zeitaufwändig sind.

Soll hingegen das Substrat als solches unterhalb bzw. tief in der Oberfläche, d.h. in einem Grenzbereich unterhalb der Oberflächen modifiziert werden, sind aus dem Stand der Technik wohlbekannte Diffusionsmethoden, wie beispielsweise Nitrieren, Carburieren, Nitrocarburieren, Oxidnitrieren, Carbonitrieren, Oxidieren oder Borieren bekannt. Diffusionsmethoden sind Verfahren, bei welchen, meist bei erhöhten Temperaturen, ein Schichtbereich im Substrat modifiziert wird, also z.B. durch Eindiffusion von häufig Stickstoff oder Kohlenstoff oder anderen reaktiven Stoffen in die Substratoberfläche hinein eine modifizierte Schicht unter der Oberfläche des Substrats gebildet wird. Ein Nachteil ist hierbei, dass die notwendigen Prozesszeiten für die Behandlung des Substrats sehr lang sind, teilweise bis zu 100 Stunden, was unwirtschaftlich und für viele industrielle Anwendungen nur bedingt geeignet ist.

Zusammenfassend kann somit gesagt werden, dass die beiden diskutierten Klassen an Methoden zwar Möglichkeiten zur Beschichtung an der Oberfläche eines Substrates bzw. Modifikation durch Diffusion in einem Schichtbereich unterhalb der Oberfläche des Substrates bieten, aber für eine effiziente Fertigung im industriellen Massstab die erwähnten Nachteile haben.

Aufgabe der Erfindung ist es daher ein neues Diffusionsverfahren zu schaffen, bei welchem die Nachteile der bekannten Verfahren und Methoden vermieden werden, und ein Diffusionsverfahren vorzuschlagen, das weniger zeitaufwändig und damit wirtschaftlicher ist, als beispielsweise das klassische Nitrieren, Carburieren oder Nitrocarburieren.

Diese Aufgabe wird durch das im Anspruch 1 definierte Verfahren gelöst.

Die abhängigen Ansprüche beziehen sich auf besonders vorteilhafte Ausführungsformen der Erfindung.

Die Erfindung betrifft somit ein Verfahren zur Modifikation eines durch eine Oberfläche begrenzten Grenzbereichs eines Substrats, wobei eine evakuierte Prozesskammer mit einer Plasmaquelle zur Erzeugung eines gerichteten Plasmastrahls zur Verfügung gestellt wird, und ferner eine reaktive Komponente in die Prozesskammer mit einem Fluss vorgegebener Grösse zugeführt und das Substrat auf eine vorgegebene Reaktionstemperatur erhitzt wird. Erfindungsgemäss wird die reaktive Komponente durch den gerichteten Plasmastrahl derart diffusionsaktiviert, sodass die reaktive Komponente mit einer vorgegebenen Diffusionsrate in den Grenzbereich des Substrats diffundiert.

Wesentlich für die Erfindung ist somit, dass die reaktive Komponente durch den gerichteten Plasmastrahl derart diffusionsaktiviert wird, sodass die reaktive Komponente in einer sehr hohen Konzentration vorliegt, insbesondere im Bereich des Plasmastrahls, und mit einer vorgegebenen Diffusionsrate in den Grenzbereich des Substrats diffundiert. Unter Diffusionsaktivierung ist ein gezieltes aufbrechen bzw. aufspalten der reaktiven Komponente beispielsweise in einzelne Atome bzw. Ionen gemeint. Besonders vorteilhaft ist dabei, dass die Diffusionaktivierung, im Vergleich zu bekannten Verfahren, im Bereich des Plasmastrahl und bei hoher Temperatur abläuft, sodass, insbesondere im Bereich des Plasmastrahls eine hohe Konzentration an reaktiven Komponenten entsteht. Aufgrund der hohen lokalen Konzentration der reaktiven Komponente im Bereich des Plasmastrahl, aber auch im Randbereich der Plasmastrahl oder in der Prozesskammer ausserhalb des Plasmastrahls, kommt es zu einem verbesserten Diffusionsverhalten, d.h. die reaktive Komponente diffundiert schneller in den Grenzbereich des Substrats. Somit reduzieren sich die Prozesszeiten um ein vielfaches und die Erfindung ermöglicht es das vorliegende Verfahren in industriellen Fertigungsprozessen sehr vorteilhaft einzusetzen und wirtschaftlich zu nutzen.

Im Gegensatz zu dem in der EP 1 160 224 B1 beschriebenen bekannten Verfahren, bei welchem ein Lichtbogen bei einer niedrigeren Spannung, meist Gleichstrom, in einem Plasmareaktor gezündet wird und die reaktive Komponente sich gleichmässig im Prozessraum verteilt, nutzt die Erfindung ein modifiziertes Verfahren des Niederdruckplasmaspritzen (engl. Low pressure plasma spraying, kurz LPPS) mit einem gerichteten Plasmastrahl, um einen gezielten Diffusionsprozess an bestimmten Grenzbereiche des Substrats herbeizuführen. Durch die vorliegende Erfindung wird somit die Diffusionsdynamik entscheidend verbessert, weil durch die Verwendung des modifizierten LPPS Prinzips eine gezielte Erhöhung der Konzentration an reaktiven Komponenten, einer vorgegebenen Diffusionsrate und vorgegebenen Verfahrensparametern erreicht bzw. verbessert wird.

In der Praxis ist die reaktive Komponente flüssig und / oder gasförmig und / oder pulverförmig und / oder eine Suspension, wobei die reaktive Komponente zur Diffusionsaktivierung, bevorzugt in den Plasmastrahl der Plasmaquelle injiziert wird und / oder in die Prozesskammer eingebracht wird. Liegt die reaktive Komponente als Suspension oder in flüssiger oder gasförmiger Form vor, dann sind drei bevorzugte Ausführungsvarianten, entweder die Injektion einer reaktiven Komponente in den Plasmastrahl in der Plasmaquelle bzw. in den freien Plasmastrahl oder in die Prozesskammer vorteilhaft möglich.

Je nach Ausführungsvariante ist ein Injektor in der Plasmaquelle vorgesehen, um eine reaktive Komponente in den Plasmastrahl zu injizieren. Der Injektor kann beispielsweise im Bereich einer Düse angeordnet sein, die zum Formen des Plasmastrahls in der Plasmaquelle vorgesehen ist. Die reaktive Komponente kann jedoch auch mittels eines Injektors in den freien Plasmastrahl injiziert werden, beispielsweise mittels eines Injektors, der in einem bestimmten Abstand von der Düsenaustrittsöffnung der Plasmaquelle angeordnet ist oder mittels eines Injektors der die reaktive Komponente in die Prozesskammer injiziert, oder anders in die Prozesskammer und / oder in den Plasmastrahl eingebracht werden. Solange der Plasmastrahl noch wenig aufgefächert ist, wird der Injektor vorteilhafterweise im Wesentlichen mittig im Plasmastrahl angeordnet. Ist der Plasmastrahl stärker aufgefächert, beispielsweise in einem Abstand von typisch grösser 0.1 m vom Plasmaquelle, können beispielsweise auch ringförmige Injektoren vorgesehen werden.

Liegt die reaktive Komponente als pulverförmiges Reagenz vor, ist in einer weiteren vorteilhaften Ausführungsform die Plasmaquelle mit einer oder mehreren Zuführungen versehen, um diese pulverartigen Feststoffpartikel, aber auch eine Suspension, zuzuführen und somit die Grenzbereiche des Substrats mittels des erfindungesgemässen modifizierten LPPS Verfahren zu modifizieren.

Die Zuführung kann zum Beispiel bis in den Bereich einer Düse geführt sein, die zum Formen des Plasmastrahls in der Plasmaquelle vorgesehen ist, um an dieser Stelle reaktive Zusätze in Form von flüssigen oder gasförmigen reaktiver Elemente oder als pulverartige Feststoffpartikel und / oder als Suspensionen in den Plasmastrahl einzubringen. Die pulverartigen Feststoffpartikel werden dabei vorteilhaft mittels eines Fördergases zugeführt. Die reaktive Komponente, die eine Kohlenwasserstoffverbindung und / oder Sauerstoff und / oder Stickstoff und / oder einen anderen reaktiven Stoff umfassen kann, diffundiert durch die Oberfläche in den Grenzbereich des Substrats, und es entsteht dabei im Grenzbereich eine Verbindung, insbesondere ein Nitrid bzw. eine Nitroverbindung, ein Karbid, ein Nitrokarbid, ein Silicid, ein Carbonitrid, ein Oxid, ein Borid oder ein Aluminid.

Mögliche Modifikationen des Grenzbereiches des Substrats umfassen somit das Nitrieren, Carburieren, Aluminieren, Nitrocarburieren, Oxidnitrieren, Carbonitrieren, Oxidieren oder Borieren des Substrates. Entscheidender Unterschied zur Beschichtung der Oberfläche des Substrats ist dabei, dass eben keine Beschichtung, welche aus dem Stand der Technik hinreichend bekannt sind, erzeugt wird, sondern es wird eine reaktive Komponente diffusionsaktiviert und mittels modifiziertem LPPS-Verfahren ein Grenzbereich im Substrat durch Diffusionsprozesse verändert. Einige Ausführungsbeispiele von Modifikationsverfahren, welche unter Verwendung des oben beschriebenen Verfahrens hergestellten wurden, werden nachstehend näher erläutert.

Als spezielle vorteilhafte Massnahme umfasst die Prozesskammer eine Wärmequelle, um die Modifikation mit einer Reaktionstemperatur innerhalb eines vorgegebenen Temperaturbereichs durchführen zu können, beispielsweise um die Diffusion gezielt steuern zu können. Als weitere Massnahme kann das Substrat mittels der zusätzlichen Wärmequelle auf eine Reaktionstemperatur vorgeheizt werden und / oder die Reaktionstemperatur kann zusätzlich oder alternativ mittels des Plasmastrahls während der Modifikation gesteuert oder geregelt werden.

Da in Abhängigkeit von der Ausführungsvariante beispielsweise das Substrat vor der Modifikation vorgeheizt werden kann, kann eine Wärmequelle für die Prozesskammer oder in der Prozesskammer für das Substrat vorteilhaft vorgesehen werden. Somit können die Verfahrensparameter, wie z.B. Diffusionsrate oder Diffusionsgeschwindigkeit etc. vor der Modifikation optimal eingestellt werden und um die Modifikation der Grenzschicht zu verbessern, also um ein wirtschaftlich effizientes Verfahren und um kurze Modifikations- bzw. Prozesszeiten zu erreichen. Das Vorheizen des Substrats kann dabei mit den gleichen Verfahrensparametern erfolgen wie das Modifizieren des Substrats, wobei es normalerweise genügt, den Plasmastrahl, der zum Vorheizen eventuell keine reaktive Komponente enthält, z.B. mit einigen Schwenkbewegungen über das Substrat zu führen. Im Idealfall wird die Wärmequelle nicht oder nur kurzfristig benötigt und der Plasmastrahl enthält die reaktive Komponente, sodass einige wenige Schwenkbewegungen ausreichen, um die Substratoberfläche auf eine benötigte Reaktionstemperatur zu erwärmen. Als zusätzliche Wärmequelle kann beispielsweise eine Infrarotlampe, eine Heizplatte, der Plasmastrahl selbst oder jede andere geeignete Wärmequelle verwendet werden. Die Temperaturkontrolle kann mit gängigen Messverfahren durchgeführt werden, z.B. unter Verwendung von Infrarot-Sensoren, Thermofühler etc..

Eine besonders vorteilhafte Massnahme sieht vor, dass der Prozesskammer, insbesondere dem Plasmastrahl, Wasserstoff zugeführt wird. Der Wasserstoff wird dabei entweder in den Plasmastrahl oder in die Prozesskammer zugeführt. Die Zuführung von Wasserstoff hat zwei Vorteile. Einerseits dient der Wasserstoff als Katalysator für den Diffusionsprozess, andererseits verhindert der Wasserstoff die Rückoxidation des Substrats, beispielsweise wenn das Substrat ein Zirkonoxid oder ein anderes Oxid ist. Die Funktion als Katalysator ergibt sich dadurch, dass eine zusätzliche Energiezufuhr im Grenzbereich des Substrats, insbesondere auf der Oberfläche, durch die Rekombination freier Wasserstoffionen erfolgt, und so die Diffusion bzw. der Modifikationsprozess unterstützt wird.

Als eine weitere Massnahme, welche die Modifikation bzw. die Diffusion optimiert, wird die Reaktionstemperatur des Substrats auf einen Wert im Bereich von 500 - 1200 °C, insbesondere 800 - 1100 °C eingestellt. Das Einstellen und Halten der Reaktionstemperatur in einem vorgegebenen Temperaturintervall ist deshalb wichtig, weil damit die Güte sowie die Prozessgeschwindigkeit festgelegt und beeinflusst werden. Vorteilhaft ist ausserdem, um beispielsweise eine gleichbleibende Qualität der Modifikation gewährleisten zu können, dass das Substrat eine möglichst homogene Temperaturverteilung aufweisst, was beispielsweise durch die Wärmequelle oder den Plasmastrahl realisiert werden kann. Aufgrund der erhöhten Temperaturen wird die Diffusionstiefe der reaktiven Komponente in die Grenzschicht des Substrats verbessert, sodass ein besonderer Vorteil des erfindungsgemässen Verfahrens ein tieferes Eindringen in das Substrat und eine daraus resultierende grössere Dicke der modifizierten Grenzschicht ist.

Es hat sich als besonders vorteilhaft erwiesen, dass, wenn die Plasmasquelle und der Substrathalter relativ zueinander bewegt werden, das Verfahren besonders effizient ist. Ferner ist es vorteilhaft, wenn das Substrat von einem Substrathalter gehalten wird, insbesondere von einem Tantal Draht gehalten wird. Nach dem Vorheizen des Substrats, insbesondere der Grenzfläche wird mit der Modifikation der durch die Oberfläche begrenzten Grenzschicht begonnen, wobei der Plasmastrahl, der je nach Ausführung die reaktive Komponente enthält, bevorzugt aber nicht notwendig mittels Schwenkbewegungen über das Substrat geführt wird. Fallweise kann zusätzlich oder an Stelle des Schwenkens des Plasmastrahls das Substrat mittels des Substrathalters bewegt werden oder es wird das Substrat während des Modifikationsprozesses mit Dreh- oder Schwenkbewegungen relativ zum Plasmastrahl bewegt. Alle genannten Massnahmen haben den Vorteil, dass dadurch eine gleichmässige Behandlung oder Beschichtung erzielt wird, und mögliche lokale Erwärmungen und/oder Beschädigungen der Substratoberfläche beziehungsweise des Substrates vermieden werden, die bei einem konstant ausgerichteten Plasmastrahl bei hoher Strahlleistung entstehen können.

In einer anderen vorteilhaften Ausgestaltung wird der Tantal Draht zum Fixieren und Halten des Substrats verwendet, sodass das Plasma und die reaktive Komponente das Substrat vollständig bedecken und eine homogene modifizierte Grenzschicht entsteht, wobei der Tantal Draht nicht mit der reaktiven Komponente reagiert und, für ein Einsatz in einem industriellen Fertigungsverfahren, besonders geeignet ist.

Ferner ist es vorteilhaft, wenn eine gesteuerte Verstellvorrichtung für die Plasmaquelle vorgesehen ist, um die Richtung des Plasmastrahls und / oder den Abstand der Plasmaquelle vom Substrat z.B. in einem Bereich von 0.05 m bis 1 m, insbesondere in einem Bereich von 0.3 m bis 0.6 m zu steuern. Wenn die Plasmaquelle und somit der Plasmastrahl mittels Schwenkbewegungen über das Substrat geführt wird, sich also während des Modifikationsprozesses mit Dreh- oder Schwenkbewegungen relativ zum Substrat bewegt, wird dadurch eine gleichmässige Behandlung und Modifikation des Grenzbereichs erzielt und mögliche lokale Erwärmungen und/oder Beschädigungen der Substratoberfläche beziehungsweise des Substrates werden vermieden.

Der Abstand der Plasmaquelle vom Substrat kann beispielsweise 0.3 m 0.6 m betragen, der Druck in der Prozesskammer 0.2 mbar bis 1 mbar und Die Leistung, die der Plasmaquelle zugeführt wird, liegt zwischen 1 kW und 100kW, insbesondere zwischen 1 kW und 40 kW. Der Druck in der Prozesskammer beträgt während des Verfahrens zwischen 0.01 mbar und 100 mbar, insbesondere zwischen 0.01 mbar und 10 mbar. Ausserdem beträgt der Gasmengenstrom der reaktiven Komponente während des Verfahrens zwischen 1 SLPM und 100 SLPM, insbesondere bei Stickstoff zwischen 1 SLPM und 10 SLPM oder bei Methan zwischen 0.1 SLPM und 2 SLPM. Durch geeignete Wahl der Parameter, z.B. die vorgenannten Parameter für bevorzugte Ausführungsbeispiele, wird es möglich hochwertige modifizierte Grenzbereiche in den behandelten Substraten herzustellen und das gesamte Verfahren derart vorteilhaft zu beschleunigen, sodass ein effizienter Einsatz im industriellen Bereich möglich ist.

Ein wesentlicher Punkt des Verfahrens der Erfindung ist somit die Ausgestaltung eines modifizierten LPPS-Verfahrens in Form einer Diffusionsmethode. Es kann somit zusammenfassend gesagt werden, dass das vorgestellte Verfahren zur Modifikation eines Grenzbereiches des Substrates, der durch die Oberfläche des Substrats begrenzt ist, die angestrebten optischen, physikalischen und mechanischen Eigenschaften des Substrats als industrielle Fertigungsmethode effizient hergestellt werden können.

Im Folgenden wird nochmals ein spezielles Ausführungsbeispiel vorgestellt, welches eine konkrete mögliche Fertigungsmethode nochmals verdeutlicht und für die Praxis besondere Bedeutung hat. Dabei werden nochmals die einzelnen Verfahrensschritten kurz vorgestellt und anhand eines Ausführungsbeispiels, welches die dekorative Modifikation des Grenzbereichs eines ZrO₂ Substrats mit Kohlenstoff C vorsieht, erklärt. Das im Folgenden beschriebene erfindungsgemässe Verfahren eignet sich dabei insbesondere zur Behandlung von Armbändern, beispielsweise für Armbanduhren um diesen untern anderem ein gewünschtes dekoratives Aussehen und Farbe zu verleihen.

Die folgenden Parameter werden in einem spezielles Ausführungsbeispiel eines erfindungsgemässen Verfahrens verwendet, wobei die verwendeten Parameter bzw. Parameterbereiche direkt nach dem Parameter angegeben sind, während beispielhaft weitere mögliche Parameter bzw. Parameterbereiche zusätzlich in Klammern angegeben sind.
- Druck in der Prozesskammer: 0.1 bis 10 mbar (0.1 bis 100 mbar)
- Gasmengenstrom: 20 bis 50 SLPM (2 bis 200 SLPM)
- Plasmagasmischung: Ar, He, H₂
- Reaktive Komponente: N₂ (1 bis 10 SLPM) für Nitrierung
- Reaktive Komponente: CH₄ (0.1 bis 2 SLPM) für Karburierung, wobei jede Molekül das C enthält verwendet werden kann.
- Der Plasmaquelle zugeführte Leistung: 1 bis 40 kW (1 bis 100 kW)
- Sprühdistanz: 300 bis 600 mm (50 bis 1000 mm)
- Enthalpie: 2'000 bis 15'000 kJ/kg
- Plasma Temperatur: 2'000 bis 15'000 K
- Plasmageschwindigkeit y: 200 bis 4000 m/s

Wird das Verfahren zur dekorativen Modifikation eines Substrats, z.B. eines Armbands oder eines Uhrengehäuses eingesetzt, kann das Substrat, beispielsweise ein Metall oder eine Keramik, vor der Modifikation eventuell vorteilhaft poliert werden, sodass das Substrat nach der Modifikation z.B. ein metallisches Aussehen, beispielsweise goldfarben hat, wenn der Grenzbereich nitriert wird oder beispielweise dunkelgrau im Fall der Carburisierung. In Abhängigkeit von der Zusammensetzung des Plasmastrahls, der reaktiven Komponente, der Position des Substrats etc. sind hierbei der Farbwahl, beispielsweise blau, rot etc., keine Grenzen gesetzt. Darüberhinaus können durch die Anwendung eines erfindugsgemässen Verfahrens auch andere Eigenschaften der Oberfläche, wie z.B. die Kratzfestigkeit, Härte usw. gezielt eingestellt werden.

Zur Fixierung wird das Substrat auf einem Substrathalter bevorzugt mittels eines Tantal Drahts befestigt, sodass das Plasma das ganze Substrat bedeckt und dieses gleichmässig modifiziert wird. Der Tantal Draht reagiert hierbei meistens nicht mit der reaktiven Komponente, sodass dieser immer wieder verwendet werden kann. Ausserdem kann der Substrathalter derart ausgestaltet werden, dass dieser, im Gegensatz zu den bekannten klassischen Verfahren, bei welchem einige wenige Werkstücke im Kreis angeordnet sind, für mehrere hundert Werkstücke verwendet werden kann. Zusätzlich werden die Plasmaquelle und das Substrat relativ zueinander bewegt, um alle Werkstücke gleichmässig zu beschichten, wobei die Reaktionstemperatur bevorzugt geregelt oder gesteuert wird.

Das Erhitzen des Substrates ist ein wesentlicher Teil des Verfahrens, da dadurch die Qualität und Geschwindigkeit des Diffusionsprozesses festgelegt wird. Wichtig ist dabei, dass das Substrat eine möglichst homogene Temperaturverteilung aufweist, welche zwischen 800 und 1100°C liegen kann, um einen optimalen Diffusionsprozess zu ermöglichen. Das Zusetzen von Wasserstoff zum Plasmagas erhöht dabei zusätzlich die Energiedichte im Grenzbereich und auf der Oberfläche des Substrats. Aufgrund der erhöhten Temperaturen wird der Wasserstoff in einzelne Wasserstoffionen aufgespalten, die wieder zu H₂ rekombinieren, wobei der Vorgang der Rekombination meistens im Grenzbereich und an der Oberfläche des Substrats stattfindet, wodurch der Modifikationsprozess weiter verbessert werden kann.

Nach dem Vorwärmen des Substrats wird mit dem eigentlichen Modifikationsprozess begonnen. Hierzu wird die reaktive Komponente, beispielsweise Methan CH₄ oder Stickstoff N₂ oder ein anderes Gas, Flüssigkeit, Suspension oder Feststoff beispielsweise in die Plasmaquelle injiziert. Die reaktive Komponente wird aufgrund der Energie des Plasmastrahl gespalten, sodass die benötigten Atome, beispielsweise Kohlenstoff C, Stickstoff N oder andere entstehen, und diese in den Grenzbereich des Substrats diffundieren können. Die Modifikation, also die Diffusion als solche, dauert wenige Minuten (ca. 30 Minuten), wobei auch ein mehrere Schritt umfassender Prozess möglich ist (z.B. ca. 2x15 Minuten), was den Diffusionprozess nochmals verbessert. Somit ist der erfindungsgemässe Prozess ca. 6 Mal schneller als alle bekannten klassischen Diffusionsprozesse, wie z.B. das klassische Nitrieren, welche oft 3 Stunden oder mehr benötigen.

In einem besonders bevorzugten Ausführungsbeispiel ist die reaktive Komponente Kohlenstoff C, welche durch Injektion von Methan CH₄ in die Plasmaquelle entsteht, in die Kristallstruktur des Grenzbereichs des Zirkoniumoxids ZrO₂ diffundiert und den Sauerstoff O₂ zumindest teilweise ersetzt, wobei Zirkoniumcarbid ZrC entsteht. Dazu wird zunächst das CH₃ Molekül mittels des Plasmastrahls gespalten und der Grenzbereich des Substrats auf Reaktionstemperatur erhitzt sowie die nötige Reaktionsenergie zur Verfügung gestellt, sodass der Kohlenstoff C in den Grenzbereich diffundieren kann. Es versteht sich, dass das reaktive Gas auch z.B. durch Berührung mit der heissen Substratoberfläche oder anders aktiviert bzw. aufgespalten werden kann. Die richtige Reaktionstemperatur einzustellen ist insbesondere deshalb wichtig, da der Diffusionsprozess in der Regel nur in einem bestimmten Temperaturbereich optimal verläuft, da, wenn das Substrat zu heiss ist, der Diffusionsprozess nicht optimal verläuft und. Z.B. zumindest teilweise unterdrückt oder umgekehrt werden kann, oder, wenn das Substrat zu kalt ist, die reaktive Komponente, also z.B. Kohlenstoff, Stickstoff oder eine andere reaktive Komponente nicht tief genug in den Grenzbereich diffundiert.

Wie bereits beschrieben, wird zunächst das CH₄ in die Plasmaquelle injiziert, beispielsweise in eine Düse der Plasmaquelle. Daher kann das Methan auch in den Plasmastrahl oder die Prozesskamme injiziert bzw. anders eingebarcht werden, wobei die reaktive Komponente in diesem Fall eine verhältnismässig grosse mittlere freie Weglänge hat und sehr schnell in Kontakt mit dem Plasmastrahl kommt. Sobald die Moleküle der reaktiven Komponente in Kontakt mit dem energiereichen Plasmastrahl kommen, kann das Molekül aufgespalten werden und es können in der Regel verschiedene Spaltprodukte, also CH, C, H₂, im Plasmastrahl gefunden werden.

Vor dem eigentlichen Modifikationsprozess wird das Substrat auf die entsprechende Reaktionstemperatur erhitzt, welche für Zirkoniumoxid z.B. bevorzugt zwischen 800 und 1100 °C liegt, und während der Modifikation, also des Diffusionsprozesses, wird dieser Bereich der Reaktionstemperatur mittels des Plasmastrahl beibehalten.

Ein ähnlicher Prozess ergibt sich, wenn anstatt Kohlenstoff C Stickstoff N verwendet wird, in diesem Fall entsteht Zirconiumnitrid, welches eine gelbe Farbe hat. Ebenso kann das Verfahren auf andere Substrate, beispielsweise Titan und auch viele andere Stoffe angewendet werden.

Nach dem Modifikationsvorgang kann das Substrat in einer Schleuse gekühlt werden und gleichzeitig mit der Bearbeitung des nächsten Werkstückes begonnen werden, um die Produktivität und Effizienz des Verfahrens nochmals zu steigern und den evakuierten Zustand der Prozesskammer beizubehalten. Im vorliegenden Ausführungsbeispiel hatte der Kühlprozess eine Dauer von 15 Minuten.

Im Folgenden wird die Erfindung anhand der Zeichnung näher erläutert. Es zeigen in schematischer Darstellung:
- Fig. 1: ein Plasmamodifikationsanlage in welcher das erfindungsgemässe Verfahren durchführbar ist;
- Fig. 2: ein modifiziertes Substrat.

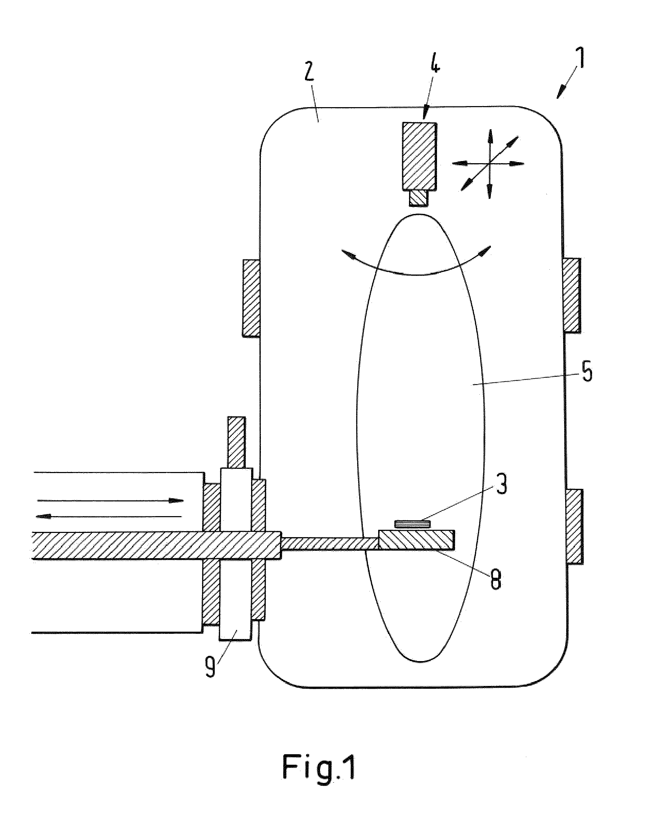

Fig. 1 zeigt ein Ausführungsbeispiel einer Plasmamodifikationsanlage 1 zur Modifikation eines durch eine Oberfläche 10 begrenzten Grenzbereichs 9 eines Substrats 3, wobei eine evakuierte Prozesskammer 2 mit einer Plasmaquelle 4 zur Erzeugung eines gerichteten Plasmastrahls 5 zur Verfügung gestellt wird, ferner eine reaktive Komponente in die Prozesskammer 2 mit einem Fluss vorgegebener Grösse zugeführt und das Substrat 3 auf eine vorgegebene Reaktionstemperatur erhitzt wird. Erfindungsgemäss wird die reaktive Komponente durch den gerichteten Plasmastrahl 5 derart diffusionsaktiviert, sodass die reaktive Komponente mit einer vorgebbaren Diffusionsrate in den Grenzbereich 11 des Substrats 3 diffundiert.

Die Plasmamodifikationsanlage 1 umfasst eine Prozesskammer 2 mit einer Plasmaquelle 4 zur Erzeugung eines Plasmastrahls 5, eine gesteuerte Pumpvorrichtung, die in Fig. 1 nicht gezeigt ist, und die mit der Prozesskammer 2 verbunden ist, um den Druck in der Prozesskammer 2 einzustellen und einen Substrathalter 8 zum Halten des Substrats 3.

Der Druck in der Prozesskammer 2 wird mittels der gesteuerten Pumpvorrichtung auf einen vorgegebenen Wert eingestellt, wobei die Plasmamodifikationsanlage 1 zusätzlich eine Injektionsvorrichtung (nicht dargestellt) umfasst, um mindestens eine reaktive Komponente in flüssiger und / oder gasförmiger und / oder pulverförmiger Form und / oder als Suspension in den Plasmastrahl 5 oder die Prozesskammer 2 einzubringen, insbesondere zu injizieren.

Bei Bedarf kann der Substrathalter 8 als verschiebbarer Stabhalter ausgeführt sein, um das Substrat aus einer Vorkammer durch eine Schleuse 9 in die Prozesskammer 2 zu bewegen. Der Stabhalter ermöglicht zusätzlich, das Substrat 3 falls erforderlich während der Modifikation zu drehen. In der Praxis wird deshalb normalerweise eine Plasmaquelle 4 eingesetzt, die üblicherweise zum thermischen Plasmaspritzen verwendet wird. Typischerweise ist der Plasmaquelle 4 mit einer Stromversorgung, zum Beispiel einer Gleichstromversorgung für einen DC-Plasmabrenner, und/oder mit einer Kühlvorrichtung und/oder mit einer Plasmagasversorgung verbunden und fallweise mit einer Versorgung mit der reaktiven Komponente und / oder einer Fördervorrichtung für pulverförmige reaktive Komponenten oder Suspensionen verbunden.

Eine herkömmliche Plasmaquelle 4 zum thermischen Spritzen kann beispielsweise eine Anode und eine Kathode umfassen, um eine elektrische Entladung zu erzeugen, wobei in dem zum thermischen Spritzen notwendigen Leistungsbereich die Anode und Kathode normalerweise gekühlt werden, beispielsweise mittels Kühlwasser.

Ein der Plasmaquelle 4 zugeführtes Prozessgas, auch Plasmagas genannt, wird in der elektrischen Entladung ionisiert, um einen Plasmastrahl 5 mit einer Temperatur von bis zu 20'000 K zu erzeugen. Der Plasmastrahl 5 verlässt die Plasmaquelle 4 mit einer Geschwindigkeit von typisch 200 m/s bis 4000 m/s. Das Prozess- oder Plasmagas kann beispielsweise Argon, Stickstoff, Helium und / oder Wasserstoff oder eine Mischung eines Edelgases mit Stickstoff und / oder Wasserstoff enthalten beziehungsweise aus einem oder mehreren dieser Gase bestehen.

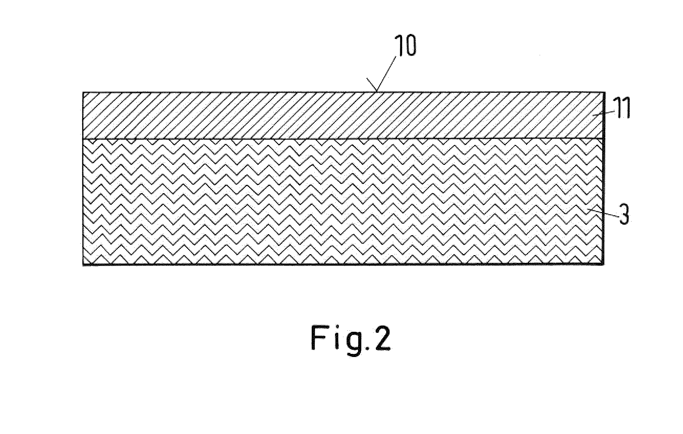

Fig. 2 zeigt schematisch ein modifiziertes Substrat 3 nach der Anwendung des erfindungsgemässen Verfahrens.

Wie zu sehen ist, befindet sich in einem durch die Oberfläche 10 des Substrats 3 begrenzten Grenzbereichs 9 des Substrats 3, welches beispielsweise ein Armband oder ein Gehäuse für eine Uhr ist, eine modifizierter Grenzbereich 11. Die Modifikation des Grenzbereichs 9 wird dabei mittels des erfindungsgemässen Verfahrens, also mittels Diffusion der reaktiven Komponenten in den Grenzbereich 11 und anschliessender Wechselwirkung der reaktiven Komponente mit dem Substrat 3, ausgebildet.

## Patentansprüche

1. Verfahren zur Modifikation eines durch eine Oberfläche (10) begrenzten Grenzbereichs (9) eines Substrats (3), wobei eine evakuierte Prozesskammer (2) mit einer Plasmaquelle (4) zur Erzeugung eines gerichteten Plasmastrahls (5) zur Verfügung gestellt wird, und ferner eine reaktive Komponente in die Prozesskammer (2) mit einem Fluss vorgegebener Grösse zugeführt wird und wobei das Substrat (3) auf eine vorgegebene Reaktionstemperatur erhitzt wird, **dadurch gekennzeichnet, dass** die reaktive Komponente durch den gerichteten Plasmastrahl (5) derart diffusionsaktiviert wird, sodass die reaktive Komponente mit einer vorgebbaren Diffusionsrate in den Grenzbereich (11) des Substrats (3) diffundiert.

2. Verfahren nach Anspruch 1, wobei die reaktive Komponente flüssig und / oder gasförmig und / oder pulverförmig und / oder eine Suspension ist.

3. Verfahren nach Anspruch 1 oder 2, wobei die reaktive Komponente zur Diffusionsaktivierung in den Plasmastrahl (5) in der Plasmaquelle (4) injiziert wird und / oder in den freien Plasmastrahl (5) injiziert wird und / oder in die Prozesskammer (2) injiziert wird.

4. Verfahren nach einem der vorangehenden Ansprüche, wobei die reaktive Komponente, die eine Kohlenwasserstoffverbindung und / oder Sauerstoff und / oder Stickstoff umfasst, im Grenzbereich (11) des Substrats mit dem Substrat reagiert, und dabei im Grenzbereich (11) eine Verbindung entsteht, insbesondere ein Nitrid bzw. eine Nitroverbindung, ein Karbid, ein Nitrokarbid, ein Silicid, ein Carbonitrid, ein Oxid, ein Borid oder ein Aluminid.

5. Verfahren nach einem der vorangehenden Ansprüche, wobei die Prozesskammer (2) eine Wärmequelle umfasst, um die Modifikation mit einer Reaktionstemperatur innerhalb eines vorgegebenen Temperaturbereichs durchführen zu können.

6. Verfahren nach einem der vorangehenden Ansprüche, wobei das Substrat (3) mittels der zusätzlichen Wärmequelle auf die Reaktionstemperatur vorgeheizt wird und / oder die Reaktionstemperatur mittels des Plasmastrahls (5) während der Modifikation gesteuert oder geregelt wird.

7. Verfahren nach einem der vorangehenden Ansprüche, wobei der Prozesskammer (2), insbesondere dem Plasmastrahl (5), Wasserstoff zugeführt wird.

8. Verfahren nach einem der vorangehenden Ansprüche, wobei die Reaktionstemperatur des Substrats (3) auf einen Wert im Bereich von 800 - 1200 °C, insbesondere 800 - 1100 °C eingestellt wird.

9. Verfahren nach einem der vorangehenden Ansprüche, wobei die Plasmasquelle (4) und ein Substrathalter (8) relativ zueinander bewegt werden.

10. Verfahren nach einem der vorangehenden Ansprüche, wobei das Substrat (3) vom Substrathalter (8) gehalten wird, insbesondere von einem Tantal Draht gehalten wird.

11. Verfahren nach einem der vorangehenden Ansprüche, wobei eine gesteuerte Verstellvorrichtung für die Plasmaquelle (4) vorgesehen ist, um die Richtung des Plasmastrahls (5) und / oder den Abstand der Plasmaquelle (4) vom Substrat (3) in einem Bereich von 0.05 m bis 1 m, insbesondere in einem Bereich von 0.3 m bis 0.6 m zu steuern.

12. Verfahren nach einem der vorangehenden Ansprüche, wobei die Leistung, welche der Plasmaquelle (4) zugeführt wird, zwischen 1 kW und 100kW liegt, insbesondere zwischen 1 kW und 40 kW.

13. Verfahren nach einem der vorangehenden Ansprüche, wobei der Druck in der Prozesskammer (2) während des Verfahrens zwischen 0.01 mbar und 100 mbar, insbesondere zwischen 0.01 mbar und 10 mbar beträgt.

14. Verfahren nach einem der vorangehenden Ansprüche, wobei Gasmengenstrom der reaktiven Komponente während des Verfahrens zwischen 1 SLPM und 100 SLPM, insbesondere bei Stickstoff zwischen 1 SLPM und 10 SLPM oder bei Methan zwischen 0.1 SLPM und 2 SLPM beträgt.
